# FASCICULE DE BREVET EUROPEEN

(11) **EP 3 608 980 B1**
(45) Date de publication et mention de la délivrance du brevet: **10.03.2021**
(21) Numéro de dépôt: 19188333.9
(22) Date de dépôt: 25.07.2019
(51) Int. Cl.: H01L 45/00, H01L 27/24

(54) **DISPOSITIF MÉMOIRE**
SPEICHERVORRICHTUNG
MEMORY DEVICE

(30) Priorité: 08.08.2018 FR 1857389
(43) Date de publication de la demande: 12.02.2020
(73) Titulaire: Commissariat à l'Energie Atomique et aux Energies Alternatives, 75015 Paris (FR); STMicroelectronics S.r.l., 20864 Agrate Brianza (MB) (IT)
(72) Inventeur: CAPPELLETTI, Paolo Giuseppe, 20030 SEVESO (MI) (IT); NAVARRO, Gabriele, 38054 GRENOBLE CEDEX 9 (FR)
(74) Mandataire: Cabinet Beaumont

(56) Documents cités:
- US-A1- 2002 131 309
- US-A1- 2008 068 879
- US-A1- 2010 072 453
- US-A1- 2013 181 183
- US-A1- 2016 072 059

## Description

### Domaine

La présente description concerne de façon générale les dispositifs mémoires et plus particulièrement les mémoires comprenant un alliage à base de germanium, d'antimoine et de tellure.

### Exposé de l'art antérieur

Les matériaux à changement de phase sont des matériaux qui peuvent basculer, sous l'effet de la chaleur, entre une phase cristalline et une phase amorphe. Comme la résistance électrique d'un matériau amorphe est significativement supérieure à la résistance électrique d'un matériau cristallin, ce phénomène peut être utile pour définir deux états de mémoire, par exemple 0 et 1, différenciés par la résistance mesurée à travers le matériau à changement de phase. Les matériaux à changement de phase les plus communs dans les mémoires sont les alliages à base de germanium, d'antimoine et de tellure.

Les mémoires à changement de phase usuelles sont généralement faites en un alliage de germanium, d'antimoine et de tellure en des proportions stoechiométriques, par exemple Ge2Sb2Te5. Un problème est que de tels alliages sont sensibles à la température. Plus précisément, leur température de cristallisation est trop basse pour supporter la gamme de température du procédé de soudure d'un circuit, particulièrement dans l'industrie automobile. Les températures de soudure entraîneraient la modification des données programmées. Un exemple de l'art antérieur se trouve dans le brevet US 2008/068879 qui divulgue un dispositif de mémoire comprenant des premières et deuxièmes cellules de mémoire à changement de phase, les premières cellules de mémoire comprenant un premier alliage à base de germanium, d'antimoine et de tellure et les deuxièmes cellules de mémoire comprenant le premier alliage et un deuxième alliage à base de germanium, d'antimoine et de tellure.

### Résumé

Un mode de réalisation pallie tout ou partie des inconvénients des mémoires à changement de phase connues.

Un mode de réalisation prévoit un dispositif mémoire comprenant des premières et deuxièmes cellules mémoire à changement de phase, les premières cellules mémoire comprenant un premier alliage à base de germanium, d'antimoine et de tellure et les deuxièmes cellules mémoire comprenant le premier alliage et un deuxième alliage à base de germanium, d'antimoine et de tellure.

Selon un mode de réalisation, le deuxième alliage a une concentration de germanium plus élevée que le premier alliage.

Selon un mode de réalisation, chaque première cellule comprend un empilement d'au moins une couche de germanium recouvrant une couche en le premier alliage.

Selon un mode de réalisation, chaque première cellule comprend un empilement d'une couche de germanium entre deux couches en le premier alliage.

Selon un mode de réalisation, chaque couche de l'empilement a une épaisseur supérieure à environ 4 nm.

Selon un mode de réalisation, chaque première cellule comprend un élément résistif en contact avec une couche inférieure de l'empilement.

Selon un mode de réalisation, la au moins une couche de germanium est dopée à l'azote.

Selon un mode de réalisation, chaque deuxième cellule mémoire comprend un empilement d'au moins une couche de germanium entre deux couches en le premier alliage et une portion en le deuxième alliage.

Selon un mode de réalisation, chaque deuxième cellule comprend un élément résistif en contact avec la portion en le deuxième alliage.

Selon un mode de réalisation, les premières et deuxièmes cellules mémoire adjacentes sont séparées par des régions isolantes.

Selon un mode de réalisation, le premier alliage est du Ge2Sb2Te5.

Un autre mode de réalisation prévoit une mémoire à programmation unique comprenant au moins un dispositif mémoire décrit précédemment.

Selon un mode de réalisation, les premières cellules correspondent à un premier état logique, et les deuxièmes cellules correspondent à un deuxième état logique.

Selon un mode de réalisation, au moins une première cellule mémoire est chauffée à une température suffisante pour transformer la première cellule en une deuxième cellule.

Selon un mode de réalisation, la au moins une première cellule est chauffée par l'intermédiaire de l'élément résistif.

### Bref exposé des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente une vue en coupe schématique d'un mode de réalisation d'une partie d'une cellule mémoire à changement de phase ;
la figure 2 représente des vues en coupe schématiques de deux étapes de fabrication du mode de réalisation de la figure 1 ;
la figure 3 représente schématiquement des vues en coupe d'un mode de réalisation d'un dispositif mémoire, avant et après la programmation ;
la figure 4 représente schématiquement une vue en coupe d'un autre mode de réalisation d'un dispositif mémoire ;
la figure 5 représente schématiquement un mode de réalisation de mémoire à lecture unique.

### Exposé détaillé

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les cellules mémoire comprennent des éléments non détaillés, par exemple des éléments de sélection, par exemple des transistors, ou des connexions électriques.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire, à l'orientation des figures.

Sauf précision contraire, les expressions "environ", "approximativement", "sensiblement", et "de l'ordre de" signifient à 10 % près, de préférence à 5 % près. Les termes "proche de" signifient à 35 % près.

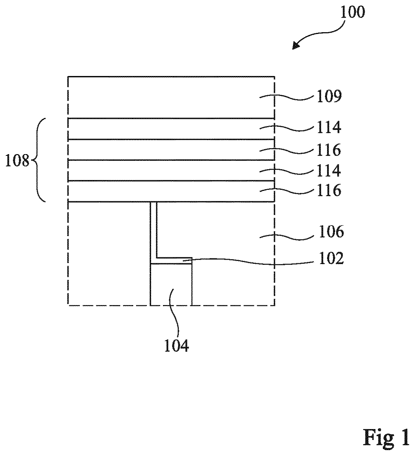

La figure 1 représente une vue en coupe schématique d'une partie d'un mode de réalisation d'une cellule mémoire à changement de phase 100.

La cellule mémoire 100 comprend un élément résistif 102 connecté à un élément de sélection, par exemple un transistor, non représenté, par l'intermédiaire d'un via conducteur 104. L'élément résistif 102 a par exemple une section en forme de L dont la partie horizontale est en contact avec le via conducteur 104. L'élément résistif 102 et le via conducteur 104 sont entourés d'une couche isolante 106. L'épaisseur de la couche 106 est telle que la face supérieure de la partie verticale de l'élément résistif est coplanaire avec la face supérieure de la couche isolante 106. L'élément de sélection est situé sous la couche 106.

La cellule mémoire 100 comprend, de plus, un empilement 108 reposant sur la face supérieure de la couche isolante 106 et sur la face supérieure de la partie verticale de l'élément résistif 102. Une couche conductrice 109 repose sur l'empilement 108. La couche conductrice 109 forme une électrode de la cellule mémoire.

L'empilement 108 comprend des couches 114 de germanium ou de germanium dopé à l'azote et des couches 116 en un premier alliage à base de germanium, d'antimoine et de tellure. Les couches de l'empilement 108 sont alternativement des couches 114 et des couches 116.

Dans le mode de réalisation de la figure 1, l'empilement 108 comprend deux couches 114 de germanium et deux couches 116 en le premier alliage. La couche inférieure de l'empilement 108 est, dans cet exemple, une des couches 116 et est située du côté de la couche 106.

Le premier alliage est un alliage stable, c'est-à-dire que les proportions des divers composants sont proches de proportions stoechiometriques. Le premier alliage est par exemple Ge2Sb2Te5, Ge4Sb4Te7 ou un alliage de germanium, d'antimoine et de tellure avec des pourcentages atomiques proches des pourcentages atomiques du Ge2Sb2Te5 ou du Ge4Sb4Te7. Le premier alliage des couches 116 est de préférence dans une phase cristalline. Les couches 114 sont par exemple en germanium non dopé ou en germanium dopé d'atomes d'azote, la teneur en azote étant de préférence inférieure à 35 % du nombre total d'atomes. Le matériau des couches 114 est par exemple dans une phase amorphe.

Les couches de l'empilement 108 ont par exemple une épaisseur supérieure à environ 4 nm, par exemple comprise entre 4 et 30 nm. Les couches 114 et les couches 116 peuvent avoir des épaisseurs différentes.

Dans certains modes de réalisation, les différentes couches 116 sont faites de différents alliages de germanium, d'antimoine et de tellure, choisis parmi les exemples donnés précédemment pour le premier alliage. Par exemple, l'empilement 108 peut comprendre une couche 114 de germanium située entre une couche 116 de Ge2Sb2Te5 et une couche 116 de Ge4Sb4Te7. Ces différents alliages seront néanmoins désignés comme étant le premier alliage dans la description suivante.

De manière plus générale, l'empilement 108 comprend au moins une couche 114 de germanium et une couche 116 en le premier alliage, la couche 116 recouvrant la couche 114. De préférence, l'empilement 108 comprend une couche 114 située entre deux couches 116 en le premier alliage. L'empilement 108 peut donc comprendre un nombre quelconque de couches, supérieur à trois. Le nombre de couches peut être pair ou impair. De plus, la couche inférieure de l'empilement 108 peut par exemple être une couche 114 de germanium.

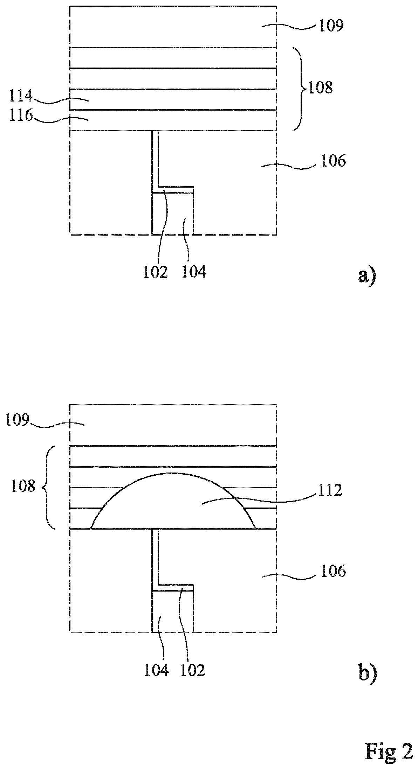

La figure 2 représente des vues en coupe schématiques de deux étapes, a) et b), illustrant la fabrication et éventuellement la programmation du mode de réalisation de la figure 1.

L'étape a) comprend les étapes de fabrication exécutées de manière à obtenir le mode de réalisation de la figure.

L'étape a) comprend :
- la formation de l'élément de sélection non représenté ;
- la formation de la couche isolante 106 ;
- la formation du via conducteur 104 ;
- la formation de l'élément résistif 102 ;
- la formation de l'empilement 108 sur la face supérieure de la couche isolante 106 et sur la face supérieure de la partie verticale de l'élément résistif 102. Plus précisément, les couches 116 en le premier alliage et les couches 114 de germanium sont alternativement formées sur toute la surface correspondant à la cellule mémoire. Dans le mode de réalisation de la figure 1, la première couche, en contact avec l'élément résistif 102, est une couche 116 en le premier alliage ; et
- la formation de la couche conductrice 109, recouvrant la couche supérieure de l'empilement 108.

A titre de variante, les couches de l'empilement 108 peuvent être en nombre et en arrangement différent, comme cela a été décrit en relation avec la figure 1. Cependant, l'empilement 108 comprend au moins une couche 114 de germanium et une couche 116 en le premier alliage.

L'étape b), suivant l'étape a), peut être considérée soit comme une étape de fabrication soit comme une étape de programmation. L'étape b) comprend une opération électrique appelée "Forming". Durant cette opération, une haute impulsion de courant, généralement supérieure aux impulsions normalement utilisées pour la programmation des cellules mémoire, se déplace entre le via conducteur 104 et la couche conductrice 109 et traverse l'élément résistif 102 et l'empilement 108.

L'élément résistif 102 chauffe jusqu'à une température, par exemple supérieure à 600 °C, de préférence supérieure à 900 °C, apte à faire fondre une portion des matériaux des couches 114 et 116. Cette opération forme une portion 112 en un alliage homogène riche en germanium à partir des portions fondues des couches 114 et 116. La portion 112 est la zone active de la mémoire à changement de phase. De préférence, l'opération de "Forming" est conçue de telle manière que la portion 112 est dans une phase cristalline à la fin de l'opération.

La portion 112 repose sur la face supérieure de la couche 106 et la face supérieure de la partie verticale de l'élément résistif 102. La portion 112 est donc en contact avec l'élément résistif 102. La portion 112 a par exemple sensiblement une section en forme de demi-cercle, ou une portion de cercle, centrée sur la zone de contact entre la portion et l'élément résistif 102.

La portion 112 de la région 108 est une portion en un deuxième alliage à base de germanium, d'antimoine et de tellure, la concentration en germanium du deuxième alliage étant supérieure à celle du premier alliage. Le deuxième alliage est, comme le premier alliage, un matériau à changement de phase, tel que cela a été décrit précédemment. Les proportions des composants du deuxième alliage ne sont, par exemple, pas stoechiométriques. La proportion de germanium dans le deuxième alliage est par exemple comprise entre 1,5 fois et 3,5 fois la proportion de germanium dans le premier alliage.

La quantité de germanium dans le deuxième alliage dépend de la quantité de germanium dans les parties chauffées, c'est-à-dire du nombre et de l'épaisseur des couches de germanium 114, par rapport à la quantité du premier alliage.

L'information écrite, ou programmée, dans la cellule mémoire est déterminée par l'état amorphe ou cristallin d'au moins une partie de la portion 112.

Les inventeurs ont déterminé que le deuxième alliage possède une température de cristallisation supérieure au premier alliage. Plus précisément, plus le deuxième alliage comprend de germanium, plus la température de cristallisation augmente.

Les températures maximales de soudure (du dispositif de la puce de circuit intégré) dans son environnement (généralement sur une carte de circuit imprimé), sont environ de 150 °C et les températures maximales atteintes durant la soudure sont approximativement de 160 °C. Ainsi, des cellules mémoire dont la température de cristallisation est supérieure à 160 °C, et étant capables de supporter des températures supérieures à 200 °C pendant quelques minutes, ne risquent pas de voir leur état modifié par la température de soudure. Ainsi, il est désormais possible de monter par soudure des dispositifs mémoire à changement de phase, sans perdre les données programmées.

Une autre possibilité aurait été de déposer directement, durant le procédé de fabrication, une couche en le deuxième alliage à la place de l'empilement 108. Cependant, comme le deuxième alliage ne correspond pas à une phase stable du diagramme de phase ternaire Ge-Sb-Te, l'alliage aurait tendance à se séparer en phases stables et distinctes pendant les étapes suivantes du procédé de fabrication. En effet, pendant le procédé de fabrication, le deuxième alliage serait exposé à des traitements thermiques à des températures relativement élevées, par exemple égales ou supérieures à 380 °C. Ces températures entraîneraient la cristallisation et la séparation du deuxième alliage. En conséquence, bien que le deuxième alliage soit déposé comme une couche homogène et amorphe, à la fin du procédé de fabrication et avant l'opération de "Forming", il serait composé de régions de phases stables séparées, distribuées aléatoirement. Il s'agirait par exemple de régions de Ge et de Ge2Sb2Te5, dont les tailles moyennes dépendraient du budget thermique du procédé de fabrication après le dépôt de la couche en le deuxième alliage.

L'opération de "Forming" telle qu'elle a été décrite en relation avec la figure 2, créerait, par la suite, une zone active similaire à la portion 112 de la figure 2. Cependant, à cause de la distribution aléatoire, en emplacement et en taille, des régions, la composition locale du deuxième alliage dans la zone active varierait d'une cellule à l'autre. Cette variabilité de l'alliage entre cellules dans la composition de la zone active aurait un impact détectable sur la distribution des paramètres de cellules dans une matrice mémoire. Cet impact serait d'autant plus important que les cellules auraient des petites dimensions critiques.

Un avantage des modes de réalisation décrits en relation avec les figures 1 et 2 est qu'ils ne font pas face à la séparation de la couche en le deuxième alliage, comme les matériaux des couches ont déjà des proportions stoechiométriques. En conséquence, toutes les cellules mémoire formées par le même procédé avec le même nombre de couches ayant les mêmes épaisseurs, et exposées, simultanément ou séparément, à la même impulsion de courant durant l'opération de "Forming" sont sensiblement identiques. Ces cellules mémoire ont donc un fonctionnement sensiblement identique. Cela reste vrai lorsque les dimensions des cellules mémoire diminuent.

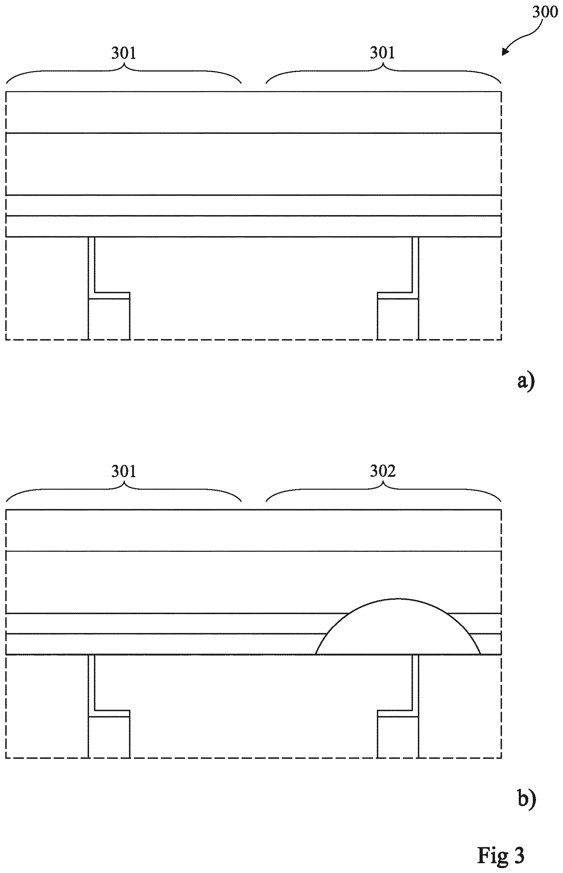

La figure 3 représente schématiquement et partiellement des vues en coupe d'un mode de réalisation d'un dispositif mémoire 300, avant et après la programmation.

Avant la programmation (structure a), le dispositif mémoire 300 comprend seulement des cellules 301 similaires aux cellules mémoire décrites en relation avec la figure 1.

Après la programmation des cellules mémoire (structure b), le dispositif mémoire 300 comprend des cellules 301 et des cellules 302 correspondant aux structures obtenues après l'étape b) du procédé décrit en relation avec la figure 2. Le dispositif mémoire 300 peut comprendre un nombre quelconque de cellules mémoire 302 et un nombre quelconque de cellules mémoire 301, indépendant du nombre de cellules mémoire 302. Dans l'exemple de la figure 3, seule une cellule mémoire 302 et une cellule mémoire 301 sont représentées.

Les cellules 301 et 302 correspondent respectivement à un premier et un deuxième état logique. Par exemple, les cellules 302 correspondent à l'état "1" et les cellules 301 correspondent à l'état "0".

La programmation des cellules mémoire comprend l'opération de "Forming". Les cellules mémoire dans lesquels on souhaite mémoriser le premier état logique reçoivent un courant suffisamment élevé pour entraîner l'étape dite de "Forming" décrite en relation avec la figure 2 et ainsi former les cellules 302. Typiquement, on réalise un réseau matriciel de cellules mémoire 301 dont certaines sont chauffées de manière à former des cellules 302.

La température de l'opération de "Forming" étant par exemple choisie pour être supérieure à la température de soudure utilisée, la soudure n'entraînera pas de modification dans les valeurs programmées en mémoire.

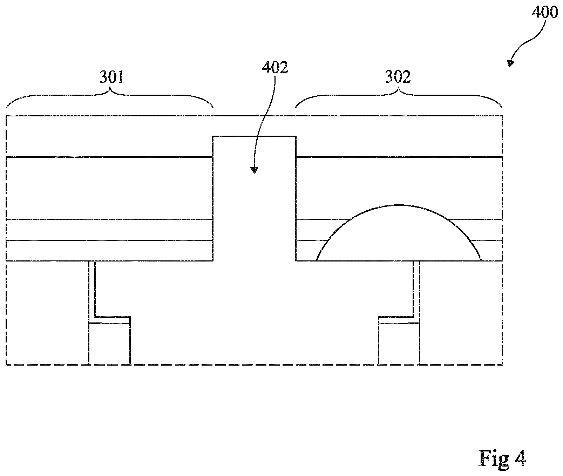

La figure 4 représente schématiquement une vue en coupe d'un mode de réalisation d'un dispositif mémoire 400. Le dispositif 400 comprend les mêmes éléments que le dispositif 300 à la différence que le dispositif 400 comprend une région isolante 402 séparant les unes des autres les cellules adjacentes. Les régions 402 permettent d'éviter que l'état d'une cellule n'interfère avec la mesure de résistance des cellules voisines.

Les dispositifs mémoire 300 et 400 décrits précédemment sont des dispositifs mémoire à lecture seule, ou à programmation unique (OTP ou One Time Programmable). Plus précisément, l'opération de "Forming" comprise dans la programmation des modes de réalisation des figures 3 et 4 est une opération ne s'effectuant qu'une seule fois qui modifie la structure de la cellule mémoire 100 de manière irréversible, détruisant localement la structure à couches. Cette opération ne s'effectuant qu'une seule fois est utilisée pour préprogrammer, au niveau de la plaquette avant l'assemblage du circuit, un code dans l'ensemble ou dans une partie du dispositif mémoire à changement de phase. Ce code sera conservé après la soudure. De plus, les cellules 302 sont des cellules mémoire à changement de phase et leurs phases peuvent basculer entre amorphes et cristallines pour programmer un état logique. Si cela est nécessaire, les cellules 301 peuvent subir l'opération de "Forming" après la fabrication du circuit et la soudure, de manière à devenir des cellules 302.

Plusieurs types de dispositifs mémoire peuvent être formés en utilisant les modes de réalisation décrits :
- i) un dispositif mémoire à lecture seule, dans lequel la programmation est faite par l'opération de "Forming" pendant le procédé de fabrication ;
- ii) un dispositif mémoire à programmation unique, dans lequel la programmation, c'est-à-dire l'opération de "Forming", est faite après l'opération d'emballage, par exemple par l'utilisateur ;

- iii) un dispositif mémoire à changement de phase, dans lequel les cellules peuvent être reprogrammées par l'utilisateur en changeant la phase de la zone active ; et
- iv) un dispositif mémoire comprenant une combinaison de dispositifs tels que décrits ci-dessus, formés sur une même puce par le même procédé de fabrication, différenciés par les opérations électriques. Par exemple, une puce comprenant une mémoire à changement de phase peut aussi comprendre des cellules mémoire à lecture seule pour les données de réparation de la matrice mémoire, le code ROM pour le contrôleur de la mémoire, les codes de fabrication, la mémoire de démarrage, etc.

Dans le cas d'un dispositif mémoire à changement de phase iii), des données peuvent être préprogrammées dans la mémoire en utilisant l'opération de "Forming", comme dans le cas des dispositifs mémoire à lecture seule et des dispositifs mémoire à programmation unique. Les données devant être programmées au niveau de la plaquette sont généralement les données de réparation, les codes de fabrication, le code ROM du contrôleur de la mémoire à changement de phase, et les données d'ingénierie qui doivent être stockées dans le dispositif dans le but de suivre son historique. Une telle préprogrammation permettrait aux données stockées dans le dispositif mémoire de supporter le procédé de soudure. Les cellules du dispositif mémoire à changement de phase iii), ceux utilisés par l'utilisateur dans une mémoire programmable effaçable, subiraient toutes l'opération de "Forming" au niveau de la plaquette, pendant le procédé de fabrication, de manière à devenir des cellules mémoire à changement de phase reprogrammables. En résumé, les cellules qui doivent être préprogrammées à un "0" logique ne subissent pas l'opération de "Forming" au niveau de la plaquette.

Dans des modes de réalisation décrits, la température de cristallisation du deuxième alliage n'a pas besoin d'être aussi élevée qu'elle devrait l'être si les données étaient préprogrammées sans utiliser l'opération de "Forming". En conséquence, le deuxième alliage peut, de manière avantageuse, comprendre moins de germanium que si les données étaient préprogrammées sans utiliser l'opération de "Forming". En effet, il a été découvert qu'augmenter la proportion de germanium dans un alliage de germanium, d'antimoine et de tellure augmente la température de cristallisation mais aussi augmente le phénomène de "Set Drift".

Le phénomène de "Set Drift" est l'augmentation de la résistance d'un alliage dans une phase cristalline (état "set"), provoqué par des températures élevées. Le phénomène de "Set Drift" est négligeable dans des alliages de germanium, d'antimoine et de tellure ayant des proportions stoechiométriques, mais a un impact significatif dans des alliages riches en germanium, comme le deuxième alliage. Le phénomène de "Set Drift" est néfaste dans une mémoire à changement de phase car cela réduit la différence entre les résistances des deux phases et peut entraîner des erreurs dans la lecture de la mémoire. Un phénomène similaire existe pour la phase amorphe (état "reset"), cependant l'augmentation de la résistance de la phase amorphe n'est pas néfaste car cela augmente la différence entre les résistances des deux états de la cellule.

Il est donc avantageux d'être capable de supporter la soudure du circuit tout en évitant le phénomène de "Set Drift".

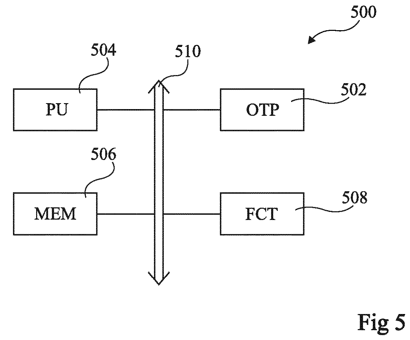

La figure 5 représente schématiquement un mode de réalisation d'une mémoire 500.

La mémoire 500 comprend :
- un ou plusieurs dispositifs mémoire, tels que les dispositifs i), ii), iii) et iv) décrits précédemment, et représentés en figure 5 par un bloc 502 (OTP). Le bloc 502 inclut également un circuit d'adressage du réseau matriciel de cellules mémoire ;
- une unité de traitement de données, représentée par un bloc 504 (PU), par exemple un microprocesseur ;
- un ou plusieurs dispositifs mémoire, représentés par un bloc 506 (MEM), et pouvant être des dispositifs mémoire différents de ceux du bloc 502. Par exemple, les dispositifs mémoire du bloc 506 peuvent ne pas être des dispositifs mémoire à changement de phase, mais être des mémoires vives (RAM), des mémoires non volatiles reprogrammables (EEPROM, flash, etc.), ou être des dispositifs mémoire à changement de phase ne pouvant être soudées. Les dispositifs mémoire du bloc 506 sont par exemple ajoutés à la mémoire 500 après les étapes de soudure ;
- un bloc 508 (FCT) comprenant d'autres fonctions électroniques, par exemple des capteurs, des circuits de commande de charges, etc. ; et
- un bus de données 510 permettant le transfert de données entre les différents composants.

A titre de variante, le bloc 506 peut ne pas être présent. Les dispositifs mémoire de la mémoire ne sont alors que des dispositifs mémoire tels que les dispositifs mémoire 300 et 400. La mémoire est alors entièrement une mémoire à lecture seule.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, bien que le procédé décrit en relation avec la figure 2 ne concerne que la formation d'une cellule mémoire, il est bien entendu qu'il est adapté à la formation simultanée d'un plus grand nombre de cellules mémoire.

Enfin, la mise en oeuvre pratique des modes de réalisation et variantes décrits est à la portée de l'homme du métier à partir des indications fonctionnelles données ci-dessus.

## Revendications

1. Dispositif mémoire (300) comprenant des premières (301) et deuxièmes (302) cellules mémoire à changement de phase, les premières cellules mémoire comprenant un premier alliage à base de germanium, d'antimoine et de tellure et les deuxièmes cellules mémoire comprenant le premier alliage et un deuxième alliage à base de germanium, d'antimoine et de tellure, dans lequel chaque première cellule (301) comprend un empilement d'au moins une couche (114) de germanium recouvrant une couche en le premier alliage (116).

2. Dispositif selon la revendication 1, dans lequel le deuxième alliage a une concentration de germanium plus élevée que le premier alliage.

3. Dispositif selon la revendication 1 ou 2, dans lequel chaque première cellule comprend l'empilement d'une couche de germanium entre deux couches en le premier alliage.

4. Dispositif selon l'une quelconque des revendications 1 à 3, dans lequel chaque couche de l'empilement (108) a une épaisseur supérieure à environ 4 nm.

5. Dispositif selon l'une quelconque des revendications 1 à 4, dans lequel chaque première cellule (301) comprend un élément résistif (102) en contact avec une couche inférieure de l'empilement.

6. Dispositif selon l'une quelconque des revendications 1 à 5, dans lequel la au moins une couche de germanium est dopée à l'azote.

7. Dispositif selon l'une quelconque des revendications 1 à 6, dans lequel chaque deuxième cellule mémoire (302) comprend un empilement d'au moins une couche (114) de germanium entre deux couches (116) en le premier alliage et une deuxième portion (112) en le deuxième alliage.

8. Dispositif selon la revendication 7, dans lequel chaque deuxième cellule comprend un élément résistif (102) en contact avec la portion (112) en le deuxième alliage.

9. Dispositif selon l'une quelconque des revendications 1 à 8, dans lequel les premières (301) et deuxièmes (302) cellules mémoire adjacentes sont séparées par des régions isolantes (402).

10. Dispositif selon l'une quelconque des revendications 1 à 9, dans lequel le premier alliage est du Ge2Sb2Te5.

11. Mémoire à programmation unique comprenant au moins un dispositif mémoire selon l'une quelconque des revendications 1 à 10.

12. Mémoire selon la revendication 11, dans laquelle les premières cellules (301) correspondent à un premier état logique, et les deuxièmes cellules (302) correspondent à un deuxième état logique.

13. Procédé d'écriture dans un dispositif mémoire selon l'une quelconque des revendications 1 à 10, dans lequel au moins une première cellule mémoire (301) est chauffée à une température suffisante pour transformer la première cellule en une deuxième cellule (302).

14. Procédé selon la revendication 13 dans son rattachement à la revendication 6, dans lequel la au moins une première cellule (301) est chauffée par l'intermédiaire de l'élément résistif (102).

## Patentansprüche

1. Speichervorrichtung (300), die erste (302) und zweite (100) Phasenwechsel-Speicherzellen aufweist, wobei die ersten Speicherzellen eine erste Legierung aus Germanium, Antimon und Tellur aufweist, und die zweiten Speicherzellen die erste Legierung und eine zweite Legierung aus Germanium, Antimon und Tellur aufweist, wobei jede erste Zelle (301) einen Stapel aus wenigstens einer Schicht (114) aus Germanium, die eine Schicht aus der ersten Legierung (116) bedeckt, aufweist.

2. Vorrichtung nach Anspruch 1, wobei die zweite Legierung eine höhere Germaniumkonzentration als die erste Legierung aufweist.

3. Vorrichtung nach Anspruch 1 oder 2, wobei jede erste Zelle (302) einen Stapel aus wenigstens einer Germaniumschicht (114) zwischen zwei Schichten aus der ersten Legierung (116) aufweist.

4. Vorrichtung nach Anspruch 3, wobei die wenigstens eine Germaniumschicht eine Dicke von mehr als ungefähr 4 nm aufweist.

5. Vorrichtung nach einem der Ansprüche 1 bis 4, wobei jede erste Zelle (302) ein Widerstandselement (102) in Kontakt mit einer unteren Schicht des Stapels aufweist.

6. Vorrichtung nach einem der Ansprüche 1 bis 5, wobei die wenigstens eine Schicht aus Germanium mit Stickstoff dotiert ist.

7. Vorrichtung nach einem der Ansprüche 1 bis 6, wobei jede zweite Speicherzelle (100) einen Stapel aus wenigstens einer Germaniumschicht (114) zwischen zwei Schichten (116) aus der ersten Legierung und einem zweiten Abschnitt (112) aus der zweiten Legierung aufweist.

8. Vorrichtung nach Anspruch 7, wobei jede zweite Zelle ein Widerstandselement (112) in Kontakt mit dem Abschnitt aus der zweiten Legierung aufweist.

9. Vorrichtung nach einem der Ansprüche 1 bis 8, wobei die ersten (302) und zweiten (100) benachbarten Speicherzellen durch isolierende Bereiche (402) getrennt sind.

10. Vorrichtung nach einem der Ansprüche 1 bis 9, wobei die erste Legierung Ge2Sb2Te5 ist.

11. Einmalig programmierbarer Speicher, aufweisend wenigstens eine Speichervorrichtung nach einem der Ansprüche 1 bis 10.

12. Speicher nach Anspruch 11, wobei die ersten Zellen (302) einem ersten logischen Zustand entsprechen und die zweiten Zellen (100) einem zweiten logischen Zustand entsprechen.

13. Verfahren zum Schreiben in die Speichervorrichtung nach einem der Ansprüche 1 bis 10, wobei wenigstens eine erste Speicherzelle (302) auf eine Temperatur aufgeheizt wird, die ausreicht, um die erste Zelle in eine zweite Zelle (100) zu transformieren.

14. Verfahren nach Anspruch 13 und nach Anspruch 6, wobei die wenigstens eine erste Zelle (302) über das Widerstandselement (102) erhitzt wird.

## Claims

1. A memory device (300) comprising first (302) and second (100) phase-change memory cells, the first memory cells comprising a first alloy made up of germanium, of antimony, and of tellurium and the second memory cells comprising the first alloy and a second alloy made up of germanium, of antimony, and of tellurium, wherein each first cell (301) comprises a stack of at least one layer (114) made of germanium covering a layer made of the first alloy (116).

2. The device of claim 1, wherein the second alloy has a higher germanium concentration than the first alloy.

3. The device of claim 1 or 2, where each first cell (302) comprises a stack of at least one germanium layer (114) between two layers of the first alloy (116).

4. The device of claim 3, wherein the at least one germanium layer has a thickness greater than approximately 4 nm.

5. The device of any of claims 1 to 4, wherein each first cell (302) comprises a resistive element (102) in contact with a lower layer of the stack.

6. The device of any of claims 1 to 5, wherein the at least one layer of germanium is doped with nitrogen.

7. The device of any of claims 1 to 6, wherein each second memory cell (100) comprises a stack of at least one germanium layer (114) between two layers (116) of the first alloy and a second portion (112) made of the second alloy.

8. The device of claim 7, wherein each second cell comprises a resistive element (112) in contact with the portion made of the second alloy.

9. The device of any of claims 1 to 8, wherein the first (302) and second (100) adjacent memory cells are separated by insulating regions (402).

10. The device of any of claims 1 to 9, wherein the first alloy is Ge2Sb2Te5.

11. A one-time programmable memory comprising at least one memory device of any of claims 1 to 10.

12. The memory of claim 11, wherein the first cells (302) correspond to a first logic state and the second cells (100) correspond to a second logic state.

13. A method of writing into the memory device of any of claims 1 to 10, wherein at least one first memory cell (302) is heated up to a temperature sufficient to transform the first cell into a second cell (100).

14. The method of claim 13 and of claim 6, wherein the at least one first cell (302) is heated via the resistive element (102).
